# EUROPEAN PATENT APPLICATION

(11) **EP 2 085 984 A1**
(43) Date of publication of application: **05.08.2009**
(21) Application number: 09151871.2
(22) Date of filing: 02.02.2009
(51) Int. Cl.: H01G 9/20, H01L 51/00

(54) **Low Band Gap Semiconductor Oxides, Processes For Making The Same, And Dye Sensitized Solar Cells Containing The Same**

(30) Priority: 04.02.2008 US 25209
(71) Applicant: General Electric Company, Schenectady, NY 12345 (US)
(72) Inventor: Karkada, Nagaveni, Kandala Halli, 560037 Bangalore (IN); Ramasesha, Sheela Kollali, 560094, Bangalore (IN)
(74) Representative: Szary, Anne Catherine

(57) **Abstract**

Low band gap semiconductor oxides (18) include nanocrystalline porous particles doped with an anion selected from the group consisting of carbon, nitrogen, fluorine, and combinations thereof, wherein the doped nanocrystalline porous semiconductor oxide has a lower band gap energy relative to undoped semiconductor oxides. A combustion synthesis process is used to fabricate the low bang gap materials. Also disclosed herein are dye sensitized solar cells (10) containing the doped semiconductor oxides (18).

## Description

### BACKGROUND

The present disclosure generally relates to low band gap semiconductor oxides such as titania and processes for making the same. Also disclosed are dye sensitized solar cells employing the low band gap oxides.

Several attempts have been made to lower the band gap of TiO₂ by transition metal doping but no appreciable change in band gap has ever been reported Most of the metal doped TiO₂ absorbs in the Visible region. The origin of the visible spectra in the case of the metal doped TiO₂ is due to the formation of a dopant energy level within the band gap of TiO₂. The electronic transition from the valence band to dopant level or from the dopant level to the conduction band can effectively red shift the band edge absorption threshold. However, the energy levels created due to metal ion doping in TiO₂ act as e⁻/h⁺ trapping centers. The presence of metal ion dopants provides more trap sites for electrons and holes in addition to surface trap sites like O2 and OH⁻¹.

Recent attempts to lower the band gap have also been made by using anionic dopants such as nitrogen (N), carbon (C), fluorine (F), sulfur (S) and phosphorous (P). The processes used in an attempt to shift the band gap included oxidative annealing TiO₂ powders and thin films in a nitrogen or an ammonia atmosphere for several hours; and oxidative annealing of TiN powder; and N-containing precursors in a sol gel process. However, these prior art processes are generally ineffective at providing large shifts in the band gap, i.e., only small shifts in the absorption spectrum have been obtained.

Solar cells, also referred to as photovoltaic cells, are commonly used to transfer energy in the form of light into energy in the form of electricity. A typical solar cell includes a photoactive material sandwiched between two electrodes. Generally, light passes through one or both of the electrodes to interact with the photoactive material to generate electricity. Most solar cells cannot use about 55% of the energy of sunlight, because this energy is either below the bandgap of the material or carries excess energy.

Recently much attention has been given to dye sensitized solar cells (DSSC) due to their low cost, simple design, and promising efficiency values. Dye sensitized solar cells are typically composed of a nanocrystalline semiconductor oxide film electrode, dye sensitizers, electrolytes, and a counter electrode sandwiched between transparent conducting substrates. Semiconductor oxides used in dye sensitized solar cells can include TiO₂, ZnO, SnO₂, Nb₂O₅, and the like, which serve as the carrier for the monolayers of dye sensitizer. Of these, the dye derived nanocrystalline titania films are most commonly used as the photoanode with the cell typically being filled with an electrolyte solution of I₃⁻/I⁻ in organic solvent. A catalyst, e.g., platinum, is disposed on a surface of the counter electrode to catalyze the cathodic reduction of the electrolyte, e.g., triiodide to iodide.

The dye-derived nanocrystalline titania films generally include a monolayer or sub monolayer coverage of the dye sensitizer to maximize efficiency. The absorption of light by a monolayer of dye is always destined to be weak. The use of a porous, nanostructured film of very high surface roughness (high porosity and high surface area) can improve efficiency since when the light penetrates the photosensitized, semiconductor "sponge", it crosses hundreds of adsorbed dye monolayers. The nanocrystalline structure equally allows a certain spreading of the radiation. The end result is a greater absorption of light and its efficient conversion into electricity relative to non-porous flat substrates If one were to increase the surface concentration of the dye, the thicker dye layer would be electrically insulating and also serve to cut off light incident on the dye molecules that are in contact with TiO₂ particle. Furthermore, when the surface concentration of the dye is increased, deactivation of the excited molecules by mutual interaction (concentration quenching) is promoted.

In these prior art dye sensitized TiO₂ solar cells, the nanocrystalline and porous TiO₂ is a wide band gap semiconductor and forms electron-hole pairs at photon energies of light greater than about 3.2 eV. Because of this, inefficiencies are inherently present since the TiO₂ absorbs photon energy in the ultraviolet (UV) region of the solar spectrum. However, UV light accounts for only a small faction of the sun's energy compared to visible light, which accounts for about 45%. By lowering the band gap energy of the TiO₂, greater absorption in the visible spectrum can be realized.

Accordingly, there is a need for a low band gap TiO₂ material, processes for making the low band gap TiO₂ material, and solar cells containing the same so as to increase the energy conversion efficiency in dye sensitized solar cells.

### BRIEF SUMMARY

Disclosed herein are processes for lowering the band gap energy of semiconductor oxides. In one embodiment, the process includes mixing a semiconductor oxide precursor with a dopant to form a solution, dehydrating the solution to form a powder of the semiconductor oxide and dopant, and combusting the powder to form a doped semiconductor oxide. In another embodiment, the process includes mixing a semiconductor oxide precursor, a dopant, and a fuel to form a solution, dehydrating the solution to form a powder of the semiconductor oxide and dopant, and combusting the powder to form a doped semiconductor oxide.

In one embodiment, the low band gap TiO₂ material comprises nanocrystalline porous TiO₂ particles doped with an anion selected from the group consisting of carbon, nitrogen, fluorine, and combinations thereof, wherein the doped nanocrystalline porous TiO₂ has a band gap energy less than 3.2 eV.

A dye sensitized solar cell comprises a photoactive layer sandwiched between first and a second electrode, wherein at least one of the first and second electrodes is transparent, wherein the photoactive layer comprises a dye sensitized nanocrystalline porous doped TiO₂ material having a band gap energy within a range of 2.1 to 2.6 eV and an electrolyte.

The disclosure may be understood more readily by reference to the following detailed description of the various features of the disclosure, the figures, and the examples included therein.

### BRIEF DESCRIPTION OF DRAWINGS

Referring now to the Figures, which are exemplary embodiments, and wherein like elements are numbered alike:
Figure 1 is an exemplary dye sensitized solar cell including a dye sensitized doped semiconductor oxide;
Figure 2 graphically illustrates XRD patterns of undoped TiO₂ powder, doped TiO₂ before heat treatment, and doped Ti02 after heat treatment at 600°C for 2 hours;
Figure 3 graphically illustrates DTA-TG curves of doped TiO₂ before heat treatment;
Figure 4 pictorially illustrates scanning electron micrographs of doped TiO₂ prepared by a solution combustion process;
Figure 5 graphically illustrates Ti (2p) core level spectrum of doped TiO₂;
Figure 6 graphically illustrates O (Is) core level spectrum of doped TiO₂;
Figure 7 graphically illustrates C (Is) core level spectrum of doped TiO₂;
Figure 8 graphically illustrates F (Is) core level spectrum of doped TiO₂;
Figure 9 schematically illustrates the energy levels of undoped and doped TiO₂;
Figure 10 graphically illustrates UV-Visible spectrum of TiO₂ doped prepared by combustion synthesis with different concentrations of dopant relative to undoped TiO₂; and
Figure 11 graphically illustrates UV-Visible spectrum of TiO₂ doped prepared by combustion synthesis with different fuels relative to undoped TiO₂.

### DETAILED DESCRIPTION

Disclosed herein is low band gap TiO₂ material, processes for making the low band gap TiO₂ material, and dye sensitized solar cells containing the same so as to increase the light absorption cross section and the energy conversion efficiency. It has been discovered that a combustion synthesis process can be used to achieve effective bulk doping of C, F, N anion into the lattice structure of the TiO₂ material so as to form the low band gap TiO₂ material. By controlling the amount of dopant used in the combustion process, the low band gap TiO₂ can be selectively tuned to exhibit band gap energies that provide absorption in the visible spectrum. Moreover, it has been found that the low band gap TiO₂ provides a higher absorption threshold in the range of 450 to 550 nm. For dye sensitized solar cell applications, the band gap energy can be tuned to form electron pairs in the visible region of the solar spectrum, e.g., 2.6 to 2.1 eV, thereby increasing the light absorption cross section.

In one embodiment, the combustion process is a solution combustion process and generally includes mixing a soluble titanium dioxide precursor salt and a dopant with a fuel. The mixture is then heated together to form the doped TiO₂, i.e., the low band gap material having a band gap energy less than 3.2 eV. The doped TiO₂ materials are nanocrystalline and porous.

In one embodiment, the combustion process includes first heating a solution of the titanium dioxide precursor salt, dopant, and fuel to a temperature effective to cause dehydration and provide an amorphous TiO₂ powder. A temperature effective to cause dehydration is about 100 to 200°C in one embodiment, and in other embodiments, a temperature of about 150°C. Once the amorphous TiO₂ powder is obtained, the powder was calcined at a temperature within a range of 400 to 600°C to provide a low band gap TiO₂. During calcination, this powder (i.e, mixture of fuel, dopant precursor, and Ti salt) undergoes decomposition and form a C, N, F doped TiO₂. This low band gap TiO₂ is nanocrystalline and porous. The solution combustion process can be with or without a flame. The particular apparatus and the parameters used to effect combustion are not intended to be limited and are well within the skill of those in the art. In one embodiment, the mixture undergoes dehydration and a spark is generated that propagates throughout the sample. In another embodiment, the process is a hydrolysis process and includes mixing the titanium dioxide precursor salt mixed with a dopant precursor in water or organic media like ethanol, isopropanol, butanol. No fuel is added. The solution is then heated to 150°C to effect dehydration and provide an amorphous TiO₂ powder, which is then calcined at a temperature within a range of 400 to 600°C to provide the low band gap TiO₂.

Advantageously, the use of the relatively low temperatures as noted in the above embodiments (i.e., less than 600°C) permits the use of flexible plastic substrates.

Suitable titanium dioxide precursor salts include, but are not limited to, titanyl nitrate. In one embodiment, titanyl nitrate is formed from titanium (IV) isopropoxide, titanium (IV) butoxide, titanium (IV) ethoxide, titanium (IV) oxychloride, titanium (IV) chloride and the like. For solution combustion synthesis, the Ti precursor is in the nitrate form. For the hydrolysis process, any of the above mentioned salts can be used directly.

Suitable dopants include, but are not limited to, an N-F dopant salt co-precursor such as ammonium fluoride; F dopant salt precursors such as NaF, LiF, HF, perfluroacetic acid, fluoropolymers; and the like.

Suitable fuels include, but are not limited to glycine, urea, ammonium acetate, hydrazine hydrate, oxalic acid dihydrazide (ODH), ammonium acetate, Hexamethylene tetramine (HMT), ammonium nitrate (these fuels can also be a C-N dopant precursor), and the like.

In an exemplary embodiment, titanyl nitrate [TiO(NO₃)₂] is mixed with ammonium fluoride in glycine and subsequently heated at 250°C to effect dehydration and form a TiO₂ powder. The combustion reaction was of the smoldering type within the appearance of a flame. The powder obtained was then sintered at 600°C to form the doped TiO₂. The doped TiO₂ was yellow in color in comparison to the white colored wide band gap TiO₂.

The dopant content, e.g., NH₄F, can be varied to provide tunability of the band gap. The stoichiometry of the metal nitrate and fuel mixtures can be calculated based on the total oxidizing and reducing valency of the fuel. X-Ray diffraction and scanning electron microscopy studies indicated that the resulting low band gap TiO₂ has an anatase crystal structure. The band gap reduction of the titanium dioxide can specifically occur through the partial substitution of oxygen with carbon, nitrogen, fluorine, sulfur and phosphorus. The partial substitution is preferably done with nitrogen.

Although reference is made specifically to titanium dioxide, the process is equally applicable to other semiconductor oxides such as, but not limited to, ZnO, SnO₂, Nb₂O₅, WO₃, and the like, which serve as carriers for the monolayers of the sensitizer their relative large surface area and medium of electron transfer to a conducting substrate.

The efficiency of solar cells can be significantly increased by using band gap tuned TiO₂ with dye coupling. The adsorption of dye molecule over low band gap TiO₂ can do both the task of light absorption and charge carrier transport effectively. Nearly quantitative conversion of incident photons into electric current can be achieved over a large spectral range extending over the whole visible region.

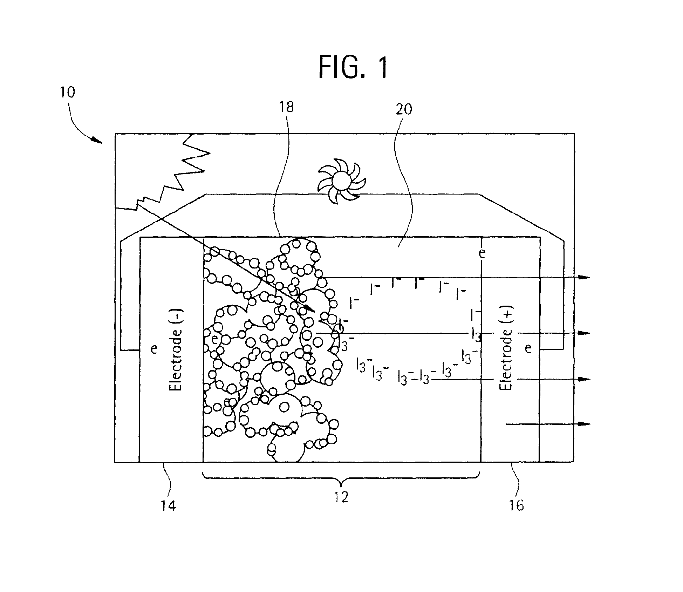

An exemplary dye sensitized solar cell 10 is shown in Figure 1 and generally includes a photoactive material 12 sandwiched between conductive electrodes 14, 16, one or both of which are transparent. The photoactive material includes a dye sensitized semiconductor oxide material 18, e.g., dye sensitized TiO₂ and an electrolyte 20. A catalyst, e.g., platinum, is disposed on a surface of the counter electrode (i.e., electrode16) to catalyze the cathodic reduction of the electrolyte, e.g., triodide to iodide.

The dye sensitizer is generally selected to absorb light at wavelengths less than 920 nm. In addition, it should be firmly grafted to the oxide surface and inject electrons into the conduction band with a quantum yield of unity. Its redox potential should be sufficiently high that it can be regenerated rapidly via electron donation from the electrolyte or a hole conductor. Finally, it should be selected to be stable enough to sustain at least 10⁸ redox turnovers under illumination, which is equivalent to about 20 years of exposure to natural light. The dye can be organic or inorganic depending on the application. Suitable inorganic dyes include, without limitation, metal complexes such as polypyridyl complexes of ruthenium, and osmium, metal porphyrin, phthalocyancine and inorganic quantum dots whereas the organic dyes generally include, without limitation, natural organic dyes and synthetic organic dyes. The particular dye sensitizer is not intended to be limited to any particular type or compound.

The electrolyte can be divided into three generally types: liquid electrolyte, quasi-solid electrolyte, and solid electrolyte. Organic solvent electrolytes are widely used for their low viscosity, fast ion diffusion, and high pervasion into the nanocrystalline film electrode. The composition of the organic liquid electrolyte includes organic solvent, redox couple, and optionally, an additive. The primary redox couple currently used is I₃⁻/I⁻. Other redox couples include Br⁻/Br₂⁻; SCN /(SCN)₂, SeCN⁻/(SeCN)₂, substituted bipyridyl cobalt (III/II), and the like. Suitable organic solvents include, without limitation, nitriles such as acetonitrile, valeronitrile, 3-methoypropioniutriole, and the like, and esters such as ethylene carbonate, propylene carbonate, γ-butyrolactone, and the like. Commonly used additives include 4-tert-butylpyridine and N-methylbenzimidazole, among others. Ionic liquid electrolytes generally include alkyl imidazolium salts, alkylpyridinium salts and trialkylmethylsulfonium slats, wherein the counterion generally includes I⁻, N(CN)₂⁻, B(CN)₄⁻, (CFCOO)₂N⁻, BF₄⁻, PF₆⁻, NCS-, and the like. The particular electrolyte is not intended to be limited to any particular type or compound.

The following examples are presented for illustrative purposes only, and are not intended to limit the scope of the invention.

In the following examples, the X-ray diffraction measurement of the low band gap TiO₂ material was carried out using a Philips Expert X-ray diffractometer from Philips, USA, with Ni-filtered Cu Kα radiation in a θ to 2θ geometry, from 5 to 100° with 0.02° step size, and 1s per step. The Tg DTA was performed on a TG/DTA system (SETARAM, 16/18AS, France), in an air atmosphere. Samples were heated from room temperature to 1000°C at 5°C/min. Particle sizes and shapes were observed using scanning electron microscopy (SEM) using a JEOL 635, Japan. The optical properties were determined by measuring optical transmittance and reflectance by depositing the low band gap material onto Pyrex glass substrates. These measurements were carried out using a ColorEye 7000A spectrophotometer (Gretag Macbeteh, USA) at room temperature in the wavelength range of 350 to 750 nm. The XPS spectra were collected using a Kratos Axis Ultra DLD spectrometer. The source was monochromatic Al Ka radiation (1486.6 eV) operated at 225 W. The lateral resolution employed was about 700 x 300 mm. The binding energy scales of all the spectra (C(1s), O(1s), Ti(2p), and F(1s)) have been charge corrected to C(1s) signal for the hydrocarbon at 284.6 eV.

### Example 1.

In this example, a titanium dioxide precursor salt was prepared as follows. TiO(NO₃)₂ solution was used as a titanium source and prepared from titanium isopropoxide [Ti(I-OPr)₄]. The titanium isopropoxide was hydrolysed under cold ice (about 4°C) with vigorous stirring to provide a white precipitate of TiO(OH)₂. The precipitated was washed in distilled water and then dissolved in 1:1 nitric acid solution to obtain a clear transparent solution of TiO(NO₃)₂.

### Example 2.

In this example, doped TiO₂ was prepared by solution combustion from a mixture of TiO(NO₃)₂ (0.01M), NH₄F (0.05 M) and glycine (0.012M). The solution was first heated on a mantle heater for dehydration and the powder obtained was treated at 600°C to provide the low band gap TiO₂ material. A series of low band gap materials were synthesized by changing the amount of NH₄F from 0.02 to 0.25 M. The doped TiO₂ was yellowish in color compared to the undoped TiO₂, which is white in color.

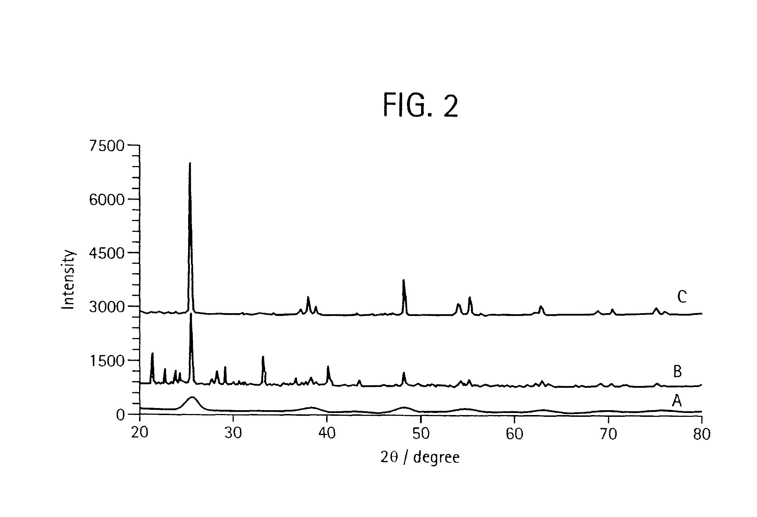

Figure 2 shows the XRD patterns of pure Ti02, and the doped TiO₂ of Example 2 before and after heat treatment. The XRD pattern of the pure TiO₂ synthesized by the solution combustion process can be indexed with anatase phase. However, in doped samples, NH₄F peaks were seen before heat treatment, which disappeared after heating that 600°C for 2 hours. The rutile and brookite phases of TiO₂ were not observed. It was found that anatase phase was restored even after calcining at 800°C suggesting that doping stabilizes the anatase phase.

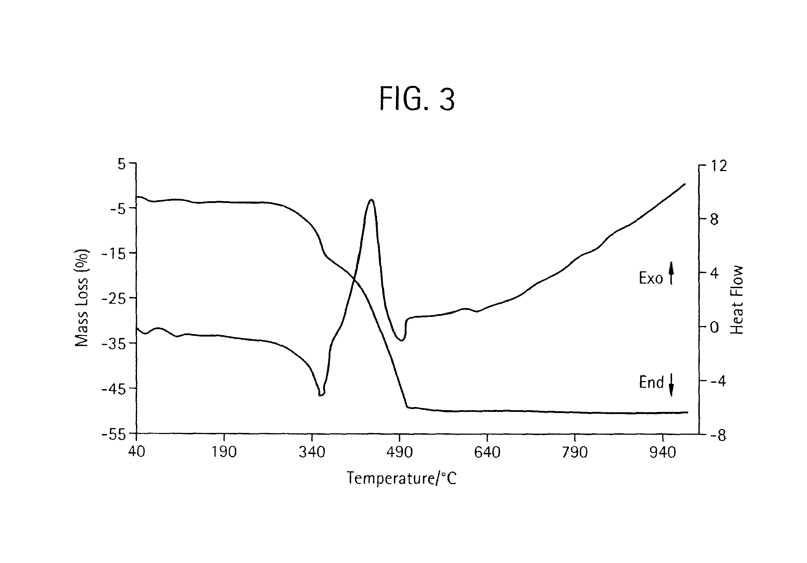

The crystalline behavior was monitored using differential thermal analysis-thermogravimetry. Figure 3 shows TG-DTA curves of doped TiO₂ (before heat treatment). At about 300°C a small exothermic peak was observed , which was presumable due to sublimation of NH₄F. A broad exothermic peak exists around 440°C, which corresponds to the crystallization of TiO₂ from amorphous phase to the anatase phase. The DTA curve also shows a small exotherm at about 500°C, which was attributed to decomposition of organic substances containing the doped TiO₂ precursor. The Tg can be divided into 3 stages. The total weight loss in the whole temperature range was 45% for the doped TiO₂. The first stage was from 250 to 410°C, which was caused by sublimation of NH₄F. The second stage was from 400 to 520°C, which can be assigned to the combustion and carbonization of organic impurities in the precursor. The third stage was from 500 to 800°C, where the mass loss was minimal and the mass was relatively constant. This phase can be attributed to the incorporation of the dopant into the TiO₂ crystalline anatase structure, i.e., carbon, nitrogen, and fluorine incorporated into the material.

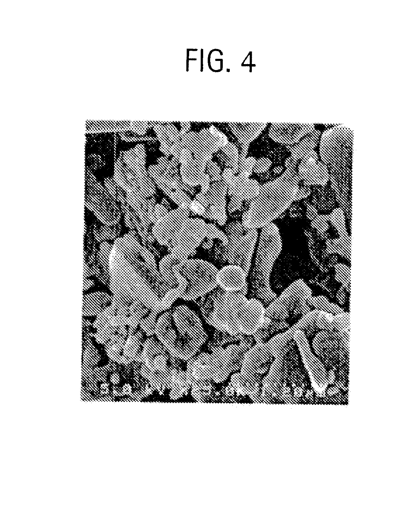

Surface morphology of doped TiO₂ is shown in Figure 4. The average particle size produced by the solution combustion process of Example 2 was about 1 micron. However, it should be noted that the undoped TiO₂ had an average particle size of a few nanometers. While not wanting to be bound by theory, it is believed that the larger sized of the doped TiO₂ can be attributed to the heat treatment at 600°C, which can coarsen the particles and the NH₄F dopant, which can act as a flux. Optimization of the processing parameters will likely result in smaller particle sizes, as may be desired for different applications.

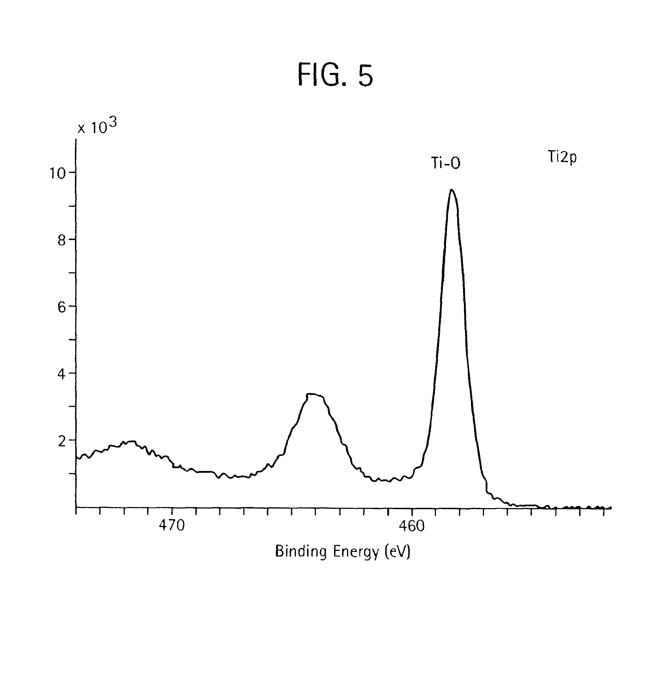

As shown in Figure 5, XPS of the Ti(2p) core level spectrum for the doped TiO₂ showed peaks at 458.4 and 464.5 eV, which are significantly lower than the binding energy of pure TiO₂ such as that obtained from Degussa P25, which had a binding energy of 459.5 eV. These peaks can be assigned to Ti⁴⁺⁽2p_{3/2}) and Ti⁴⁺(2p_{1/2}), respectively. While not wanting to be bound by theory, the shift in the binding energy of Ti 2p_{2/3} peak to lower energies might be assigned to the reduction of Ti⁴⁺ to Ti³⁺.

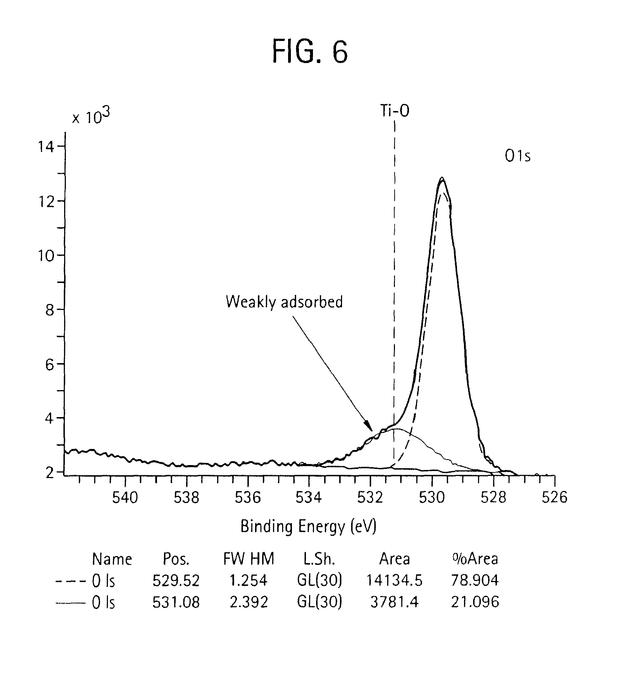

In Figure 6, the O(1s) core level spectrum of the doped TiO₂ shows two peaks at 529.5 and 531.0 eV. The peak at 531.0 eV could be attributed to the surface hydroxyl groups or chemisorbed water molecules on the doped titania while the 529.5 eV peak can be attributed to O²⁻ from the lattice.

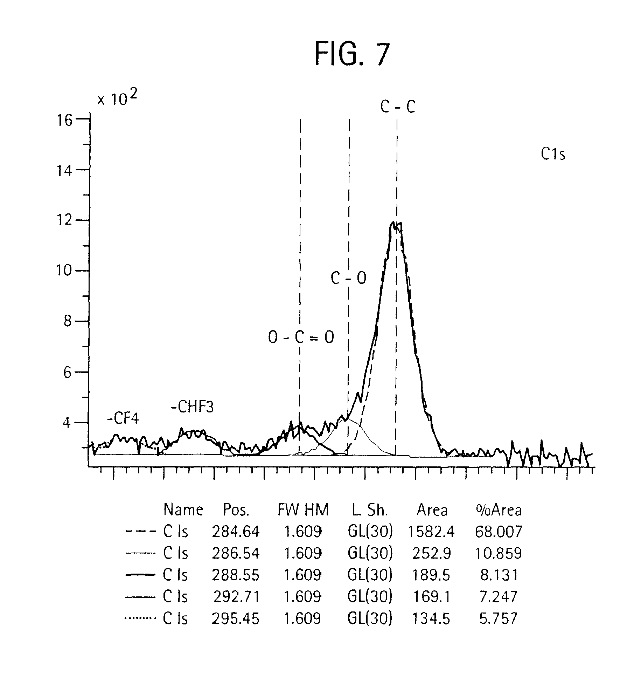

In Figure 7, the C(1s) spectrum showed a peak at 284.6 eV, which can be assigned to graphitic carbon. Again, not wanting to be bound by theory, this peak may be caused by hydrocarbon/oxidized hydrocarbon on the doped TiO₂. However, it is feasible that the carbon is present due to the hydrocarbon-based fuel used in the combustion synthesis. Further, the maximum heating temperature was 600°C during the synthesis and there was no observed weight loss in TGA above 600°C, which would indicate that there was no free carbon left. However, the possibility of absorption of carbon anions cannot be ruled out.

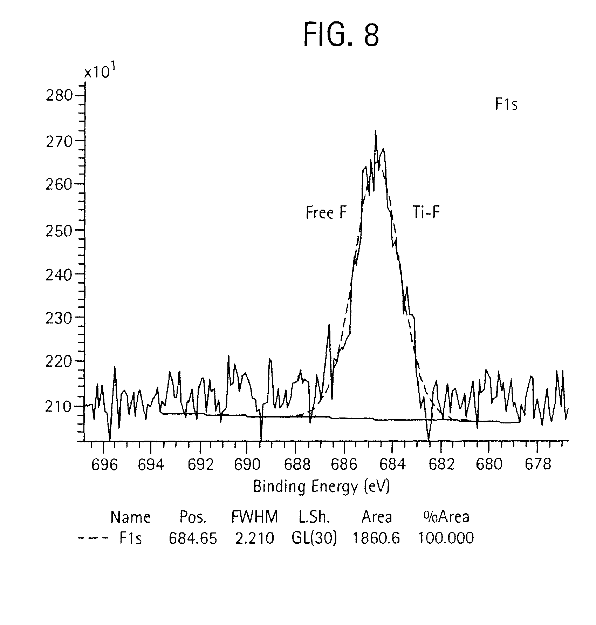

In Figure 8, the F(1s) spectrum is shown and does not show any peaks around 688eV, which suggests the absence of free fluorine. However, the peak at about 685eV may be due to the presence of Ti-F bonds.

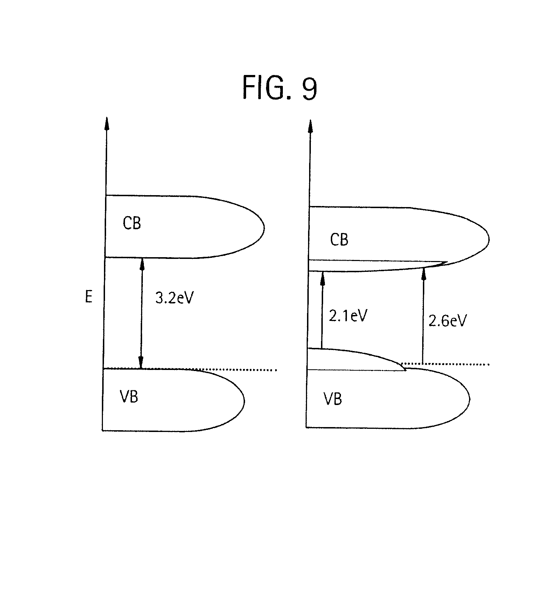

XPS showed that the reduced bad gap in doped TiO₂ is predominantly due the substitution of F⁻ in the TiO₂ structure on the oxygen sites. The quantitative estimation from XPS peak for F(1s) showed that there was a 2.7 atom % fluorine present as Ti-F linkages. The presence of F⁻ in the structure eventually reduced some Ti⁴⁺ to Ti³⁺. The presence of Ti³⁺ lowered the conduction band as shown schematically in Figure 9 and hence reduced the band gap of TiO₂ to 2.6 eV relative to the value of 3.2 eV for undoped TiO₂. Further, presence of carbon in the TiO₂ structure as Ti-C linkages leads to the shift in valance bands towards higher energies resulting in a 2.1 eV transition. It should be noted that band structure calculation were made by local density approximation and showed that C(2p) levels were located at just above Fermi level (i.e., valance band in this case) of TiO₂.

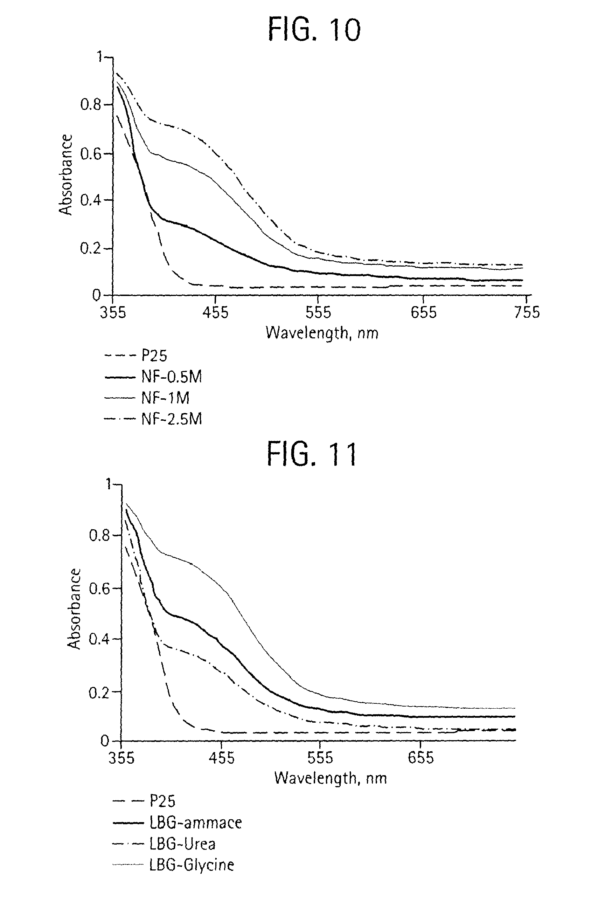

The absorption spectra of doped TiO₂ as a function of dopant concentration is shown in Figure 10. A new absorption band was observed in the visible region of 400 to 500nm due to formation of Ti⁺³ affecting the conduction band and the presence of C(2p) levels affecting the valence band as discussed above. The fundamental absorption edge of doped TiO₂ was also shifted to higher wavelength, corresponds to the 2.6 eV transition. For various doping concentration, the amount of shift was different. Moreover, the absorbance increased with the atomic percentage of dopant.

As shown in Figure 11, the fuel used in the combustion synthesis also had a strong effect on the visible absorption properties. The maximum visible absorption was observed for glycine compared to other fuels such as urea and ammonium acetate. The data is shown relative to undoped TiO₂. These results support the conclusion that the anions are incorporated into the lattice of the doped TiO₂.

It is to be noted that the terms "first," "second," and the like as used herein do not denote any order, quantity, or importance, but rather are used to distinguish one element from another. The terms "a" and "an" do not denote a limitation of quantity, but rather denote the presence of at least one of the referenced item. The modifier "about" used in connection with a quantity is inclusive of the stated value and has the meaning dictated by the context (e.g., includes the degree of error associated with measurement of the particular quantity). It is to be noted that all ranges disclosed within this specification are inclusive and are independently combinable. All amounts, parts, ratios and percentages used herein are by weight unless otherwise specified.

While the invention has been described with reference to the embodiments thereof, it will be understood by those skilled in the art that various changes can be made and equivalents can be substituted for elements thereof without departing from the scope of the invention. In addition, many modifications can be made to adapt a particular situation or material to the teachings of the invention without departing from the essential scope thereof. Therefore, it is intended that the invention not be limited to the particular embodiments disclosed as the best mode contemplated for carrying out this invention, but that the invention will include all embodiments falling within the scope of the appended claims.

For completeness, various aspects of the invention are now set out in the following numbered clauses:
1. A low band gap TiO₂ material, comprising:
   nanocrystalline porous TiO₂ particles doped with an anion selected from the group consisting of carbon, nitrogen, fluorine, and combinations thereof, wherein the doped nanocrystalline porous TiO₂ has a band gap energy less than 3.2 eV.
2. The low band gap TiO₂ material of clause 1, wherein the band gap energy absorbs in the visible region.
3. The low band gap TiO₂ material of clause 1, wherein the doped nanocrystalline porous TiO₂ has an average particle size less than 1.0 microns.
4. The low band gap TiO₂ material of clause 1, wherein the doped nanocrystalline porous TiO₂ comprises Ti³⁺ in its lattice structure.
5. The low band gap TiO₂ material of clause 1, wherein the doped nanocrystalline porous TiO₂ comprises Ti-C linkages.
6. The low band gap TiO₂ material of clause 1, wherein the band gap energy is 2.1 to 2.6 eV.
7. The low band gap TiO₂ material of clause 1, wherein The low band gap TiO₂ material of Claim 1, wherein the doped nanocrystalline porous TiO₂ comprises Ti-F linkages.
8. The low band gap TiO₂ material of clause 1, wherein The low band gap TiO₂ material of Claim 1, wherein the doped nanocrystalline porous TiO₂ comprises Ti-N linkages.
9. The low band gap TiO₂ material of clause 1, wherein the low band gap TiO₂ material consists of an anatase structure.
10. The low band gap TiO₂ material of clause 1, wherein the low band gapTiO₂ material consists of an anatase structure after heating at temperatures greater 600°C.
11. A process for lowering a band gap energy of a semiconductor oxide, the process comprising:
   mixing a semiconductor oxide precursor salt and a N-F dopant salt to provide a solution;
   dehydrating the solution to form a powder;
   combusting the powder at a temperature of 400 to 600°C to form a nanocrystalline porous doped semiconductor oxide, wherein the nanocrystalline porous doped semiconductor oxide has a lower band gap energy relative to an undoped semiconductor oxide.
12. The process of clause 11, further comprising adding a fuel to the solution.
13. The process of clause 11, wherein the semiconductor oxide is selected from a group consisting of ZnO, SnO₂, Nb₂O₅, WO₃and TiO₂.
14. The process of clause 11, wherein the semiconductor oxide is TiO₂.
15. The process of clause 11, wherein the semiconductor oxide precursor salt is titanyl nitrate and the N-F dopant salt is ammonium fluoride.
16. The process of clause 14, wherein the band gap energy subsequent to combusting the powder is 2.1 to 2.6 eV.
17. The process of clause 14, wherein the nanocrystalline porous doped TiO₂ comprises Ti³⁺ in its lattice structure.
18. A dye sensitized solar cell comprising:
   a photoactive layer sandwiched between first and a second electrode, wherein at least one of the first and second electrodes is transparent, wherein the photoactive layer comprises a dye sensitized nanocrystalline porous doped TiO₂ material having a band gap energy within a range of 2.1 to 2.6 eV and an electrolyte.
19. The dye sensitized solar cell of clause 18, wherein the nanocrystalline porous doped TiO₂ comprises Ti³⁺ in its lattice structure.
20. The dye sensitized solar cell of clause 18, wherein the nanocrystalline porous doped TiO₂ material consists of an anatase structure.

## Claims

1. A low band gap TiO₂ material, comprising:
nanocrystalline porous TiO₂ particles doped with an anion selected from the group consisting of carbon, nitrogen, fluorine, and combinations thereof, wherein the doped nanocrystalline porous TiO₂ has a band gap energy less than 3.2 eV.

2. The low band gap TiO₂ material of Claim 1, wherein the doped nanocrystalline porous TiO₂ comprises Ti³⁺ in its lattice structure.

3. The low band gap TiO₂ material of Claim 1 or Claim 2, wherein the doped nanocrystalline porous TiO₂ comprises Ti-C linkages.

4. The low band gap TiO₂ material of any one of the preceding claims, wherein the band gap energy is 2.1 to 2.6 eV.

5. The low band gap TiO₂ material of any one of the preceding claims, wherein the doped nanocrystalline porous TiO₂ comprises Ti-F linkages.

6. The low band gap TiO₂ material of any one of the preceding claims, wherein the doped nanocrystalline porous TiO₂ comprises Ti-N linkages.

7. The low band gap TiO₂ material of any one of the preceding claims, wherein the low band gap TiO₂ material consists of an anatase structure.

8. A process for lowering a band gap energy of a semiconductor oxide, the process comprising:
mixing a semiconductor oxide precursor salt and a N-F dopant salt to provide a solution;
dehydrating the solution to form a powder;
combusting the powder at a temperature of 400 to 600°C to form a nanocrystalline porous doped semiconductor oxide, wherein the nanocrystalline porous doped semiconductor oxide is selected from a group consisting of ZnO, SnO₂, Nb₂O₅, WO₃and TiO₂ and has a lower band gap energy relative to an undoped semiconductor oxide.

9. The process of Claim 8, wherein the semiconductor oxide precursor salt is titanyl nitrate and the N-F dopant salt is ammonium fluoride.

10. A dye sensitized solar cell comprising:
a photoactive layer sandwiched between first and a second electrode, wherein at least one of the first and second electrodes is transparent, wherein the photoactive layer comprises a dye sensitized nanocrystalline porous doped TiO₂ material having a band gap energy within a range of 2.1 to 2.6 eV and an electrolyte.
